# EUROPEAN PATENT APPLICATION

(11) **EP 2 224 471 A1**
(43) Date of publication of application: **01.09.2010**
(21) Application number: 07859875.2
(22) Date of filing: 20.12.2007
(51) Int. Cl.: H01L 21/308, H01L 31/04

(54) **THICKENED ETCHING COATING LIQUID, AND METHOD FOR SELECTIVELY ETCHING SUNLIGHT POWER GENERATION ELEMENT SUBSTRATE FOR SOLAR CELL USING THE THICKENED ETCHING COATING LIQUID**

(71) Applicant: Teoss CO., LTD., 9-15, Honmachi 3-chome Kokubunji-shi Tokyo 185-0012 (JP)
(72) Inventor: MURAI, Tsuyoshi, Kokubunji-shi Tokyo 1850012 (JP); KONAKA, Toshinori, Kokubunji-shi Tokyo 185-0012 (JP)
(74) Representative: Mounteney, Simon James
(86) International application number: PCT/JP2007/074478
(87) International publication number: WO 2009/081453

(57) **Abstract**

A HIGH VISCOSITY ETCHANT AND A SELECTIVE ETCHING METHOD FOR PHOTOVOLTAIC ELEMENT SUBSTRATES OF SOLAR CELLS USING THE SAME

A main subject of the present invention is to provide a high viscosity etchant EL and a selective etching method using the same which etches a photovoltaic element substrate to a set depth concretely and does not spread undesirably.

The high viscosity etchant EL of the present invention comprises an etchant being an alkaline solution for etching a photovoltaic element substrate 12; a viscosity increasing additive derived from a plant for increasing a viscosity of the etchant EL. The selective etching method comprises applying the high viscosity etchant EL to a surface of the photovoltaic element substrate 12; reacting the high viscosity etchant EL and the photovoltaic element substrate 12 by heating them; washing the photovoltaic element substrate 12 with pure water.

## Description

### Background of the Invention

### Field of the Invention

The present invention relates to high viscosity etchant for production of solar cells and a selective etching method using the same.

### Description of the Related Art

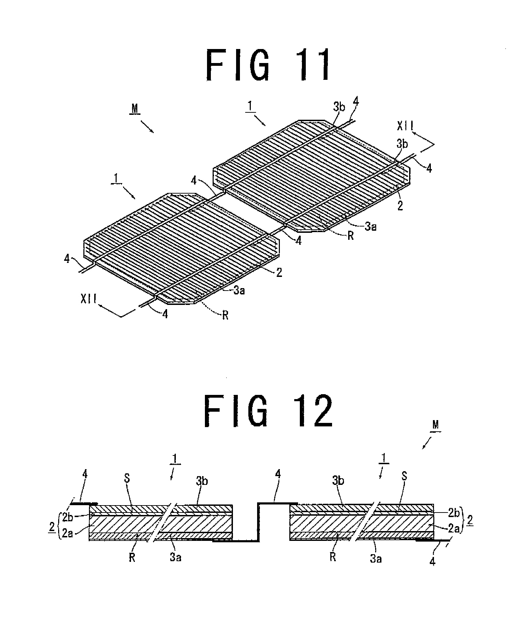

Solar cells are attracting attention of people recently; the solar cells which can convert energy of sun light directly into electricity are suitable for the Global Warming Countermeasures. As shown in Fig.11 and 12, the solar cells 1 include photovoltaic element substrates 2 and two pairs of reverse electrodes 3a and surface electrodes 3b which are set both side of each the photovoltaic element substrate 2. The solar cells each of which are placed adjacently consist a solar cell module M by electrically connecting the reverse electrode 3a of one of the solar cells 1 to the surface electrode 3b of the other of the solar cells 1 with lead wires (inter connectors) 4. Photovoltaic equipment is produced by packaging the solar cell module M.

The photovoltaic element substrate 2 which is a main body of the solar cell 1 is produced by slicing single-crystal silicon or polycrystalline silicon which is added a small amount of boron or phosphorus into approximately 250 µm thick. The silicon including boron is p-type silicon. And the silicon including phosphorus is n-type silicon. When a small amount of boron is added to all-surface of the p-type silicon 2 by thermal diffusion method, a portion (i.e. a thin surface layer 2b) of the substrate 2 of which a concentration of phosphorus is higher than that of boron obtains n-type semiconductor property (n-layer). A p-n junction S is made on a boundary surface between the p-type silicon and the n-layer, When a small amount of boron is added to a surface of the n-type silicon 2 by thermal diffusion method, a portion (i.e. a thin surface layer 2b) of the substrate 2 of which a concentration of boron is higher than that of phosphorus obtains p-type semiconductor property. The p-n junction S is made on a boundary surface between the p-type silicon and the n-type silicon. When the substrate 2 is irradiated by sunlight or the like, the p-n junction divides a positive pole (the p-type conductor side) and a negative pole (the n-type conductor side). By connecting the positive pole and the negative pole through a load, an electric current passes.

The generating structure is produced by making the layer which contains phosphorus (or boron) by treating the thermal diffusion method to the surface of the p-type (or n-type) silicon substrate 2 to approximately 0.2µm thick. For the thermal diffusion method using phosphorus, impurity gas or liquid (i.e. POCl₃ [phosphoryl chloride], PH₃ [phosphine], P₂O₅ [phosphorus pentoxide], or H₃PO₄ [phosphoric acid]) which contains phosphorus is contacted to the surface of the substrate 2 and heated at approximately 900 °C. Then, the thin surface layer 2b is produced on the surface of the substrate 2. This method is applied in a similar manner for using impurity gas or liquid which contains boron.

When diffusing phosphorus (or boron) into the substrate 2 by applying a source of diffusion on the surface of the substrate 2, the phosphorus (or boron) which is applied or put on the surface evaporates. Then the evaporated phosphorus (or boron) is diffused into a "non-required area" (i.e. side walls, all of reverse side, or edge portion of reverse side of the substrate 2). The diffused layer of phosphorus (or boron) is forced to be produced on the "non-required area". Therefore, it is necessary to remove the "non-required area" for exposing a base layer of a reverse electrode forming area R before forming the reverse electrode 3a, to isolate a "required area" (i.e. the thin surface layer on the surface of the substrate 2) from the "non-required area".

There are some methods to remove the thin surface layer (n-layer) 2b of the side wall of the treated silicon substrate (i.e. sand-blast method and plasma etching method). To operate these methods efficiently, 300 to 500 sheets of the treated substrates are stacked to one block. After that, the thin surface layer 2b formed on a side of the block (i.e. a side wall of the treated silicon substrates) is removed by the sand blast method or the plasma etching method.

To operate the sand blast method or the plasma etching method, it is necessary to lay the treated silicon substrates and press for preparation to avoid gaping between a surface of one silicon substrate and a surface of another silicon substrate (especially edge portions of the surfaces). But the photovoltaic element substrates 2 are very thin, not completely flat, and have uneven thickness. And the surfaces of each substrate are not parallel each other. Consequently, the substrates 2 have a problem that they are easy to be broken with a small mechanical impact such as a pressure. Furthermore, though processes before and after this process can treat the substrates 2 consecutively, this batch process can not treat the substrates 2 consecutively. Therefore, efficiency of production can not be higher.

Wet etching method may be applied to treat the substrates 2. The wet etching method is that letting the reverse (a side which the reverse electrode 3a is applied.) of the treated silicon substrate upward by fixing to a spin-check of a spinner, dropping low viscosity (almost water) etchant on a central of a reverse of the treated silicon substrate, spin coating the etchant to all the reverse of the treat silicon substrate with an centrifugal force, and finally removing the thin surface layer 2b from the treated silicon substrate before washing and drying (e.g., Patent document 1. Japanese Laid-Open Patent Publication No.2007-88402).

But a viscosity of the etchant 5 used for ordinal Wet etching method is almost the same of water. When the etchant 5 is used for the spin coat method, the etchant 5 undesirably wraps the "required area" that is the surface of the photovoltaic element substrate 2 (the surface which the surface electrode 3b is applied.) Consequently, a periphery area of the thin surface layer 2b which is formed on the surface of the photovoltaic element substrate 2 is forced to be removed.

Though such a problem is solved by masking the surface of the photovoltaic element substrate 2 with etchant 5 resist material before spin coat the etchant 5 on the photovoltaic element substrate 2, masking is a lot of work that causes a cost of the solar cell 1 increasing.

The present invention is invented in view of the above-described problems of the conventional art. Thus, a main subject of the present invention is to provide a high viscosity etchant which does not damage a side of a photovoltaic element substrate for a solar cell, not wrap a "required area" that is a surface to be applied a surface electrode of the photovoltaic element substrate, and etches to a set depth and area correctly; and to a provide a selective etching method (a method for etching a set area selectively and correctly) for a photovoltaic element substrate of a solar cell using the same.

A first aspect of the present invention is a high viscosity etchant EL comprising: an etchant being an alkaline solution for exposing a base layer 17 with removing a part of a thin-surface layer 18 of a p-n junction S of a photovoltaic element substrate 12 of a solar cell; a viscosity increasing additive derived from a plant for increasing a viscosity of the etchant EL.

A high viscosity etchant EL of the present invention includes a viscosity increasing additive. The viscosity of the high viscosity etchant EL is increased. The high viscosity etchant does not spread out after application to the photovoltaic element substrate 12, diffuse, and cohere undesirably. Consequently, it is not necessary to mask before the application of the high viscosity etchant EL.

When the high viscosity etchant is heated for improving an etching reaction after application, the etching reaction might be interrupted with evaporation of moisture from the surface of the high viscosity etchant EL in the reaction. But in the evaporation, a paste-like film T of a viscosity increasing additive derived from a plant is formed on a surface of the high viscosity etchant EL. A liquid (the moisture which is not evaporated) of the high viscosity etchant EL is wrapped with the film T of the viscosity increasing additive. Amount of the evaporation from the high viscosity etchant EL is decreased. The etching reaction can be continued until a set depth (generally, not more than 0.5 µm in a technical field of solar cells.) In addition, a scattering of the etchant can be reduced or canceled in the etching reaction after forming the film T.

The etchant for the present invention is an alkaline solution such as sodium hydroxide (NaOH), potassium hydroxide (KOH), or the like for silicon etching. And the viscosity increasing additive is an aqueous paste which is formed by heating after kneading material derived from a plant such as flour, starch of dogtooth violet, cornstarch, or the like. It is a common with this invention that the photovoltaic element substrate 12 has a thin-surface layer 18 of a p-n junction S formed on the surface and has a p-n junction.

A second aspect of the present invention is a selective etching method for removing a part of a surface of a thin surface layer 18 of a p-n junction S from a photovoltaic element substrate 12 having the p-n junction S to expose a base layer 17, comprising:
applying the high viscosity etchant EL according to claim 1 to a reverse electrode forming-area R which is formed on all of reverse of the photovoltaic element substrate 12 and/or all side of the substrate 12;
separating the thin surface layer 18 and the reverse electrode forming-area R by reacting the high viscosity etchant EL to an etchant-applied area of the photovoltaic element substrate 12 by heating the substrate 12;
removing the high viscosity etchant EL by washing the etchant EI with pure water.

In other words, this selective etching method can be applied to a continuous treatment by a tact conveying method.

This selective etching method of the present invention is to separate the thin surface layer 18 and the reverse electrode forming-area R by a correct etching to the etchant-applied area after applying the high viscosity etchant EL to around the reverse electrode forming-area R of the photovoltaic element substrate 12 or by a correct etching to the all side of the substrate 12.

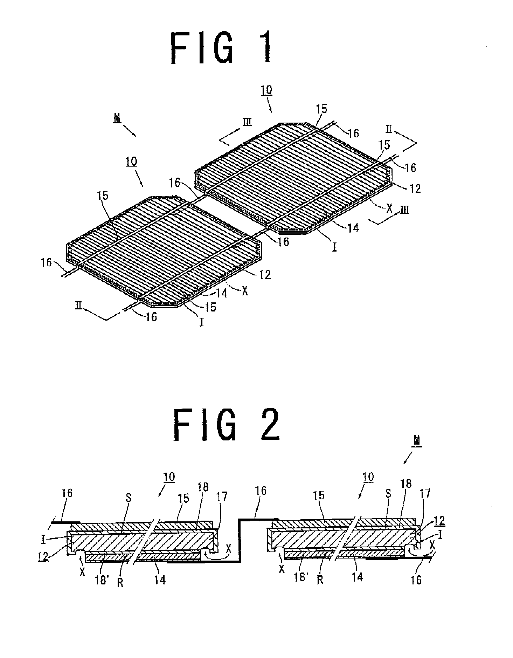

The high viscosity etchant EL can ensure the etching of the photovoltaic element substrate 12 to the depth that the base layer 17 (a p-type interior layer in a following embodiment) is exposed without undesired spread or cohere in applying to the photovoltaic element substrate 12 or etching. No damage layer is formed and no need to etch all of reverse as the wet etching using the spinner. Consequently, the thin surface layer 18 (an n-type in a following embodiment) can be separated electrically from the reverse electrode forming-area R by exposing the base layer 17 around the reverse electrode forming-area R (In FIG.2, "X" part is equal to the high viscosity etchant-applied area.) with a small amount of the high viscosity etchant EL without a large amount of etchant or masking.

When the high viscosity etchant EL is reacted to the photovoltaic element substrate 12, the high viscosity etchant EL may be reacted to the photovoltaic element substrate 12 of which the etchant-applied area X at a circumference of the reverse electrode forming-area R with holding the photovoltaic element substrate 12 upside down.

When the high viscosity etchant EL is reacted to the photovoltaic element substrate 12, by holding the photovoltaic element substrate 12 upside down, a shape of the high viscosity etchant EL hanged by the gravity and a surface tension at the etchant-applied area X where the etchant EL applied as fine lines (if the etchant EL applied as points, the shape of the etchant EL will be a teardrop-adhered shape.) will be semi-cylindrical. Consequently, the etchant EL will not spread from the etchant-applied area X. And in case that micro drops of the high viscosity etchant EL scatter with gushes of reacted gas from the etching reaction in a beginning of the reaction, the micro drops fall without being applied to the photovoltaic element substrate 12. Therefore, undesirable etching at outside of the high viscosity etchant-applied area is avoided.

According to the present invention, the high viscosity etchant which can keep in applied area is provided. When the etchant is applied to the circumference of the reverse electrode forming-area of the photovoltaic element substrate or all of a side of the substrate, the etchant does not wrap to the surface of the photovoltaic element substrate on its high viscosity.

With the film of the viscosity increasing additive formed in "heating" step, amount of the evaporation from the high viscosity etchant is decreased. The etchant-applied area can be etched selectively until the base layer is exposed surely, because the etchant is difficult to be dried up. Furthermore, by doing the method with a machine applied the present invention, wafers can be treated continuously and manufacturing cost of wafers and a rate of breakage of the photovoltaic element substrate will decrease.

### Brief Description of the Drawings

FIG. 1 is a perspective view of a solar cell module.
FIG. 2 is a cross-sectional view taken on line II-II of FIG. 1.
FIG. 3 is a cross-sectional view taken on line III-III of FIG. 1.
FIG. 4 is a diagram showing a photovoltaic element substrate of which surface, reverse, and side is covered with n-layer (a thin surface layer).
FIG. 5 is a flow diagram of wet etching method.
FIG. 6 is a diagram of a reverse of a photovoltaic element substrate with high viscosity etchant.
FIG. 7 is a schematic cross-sectional view for explaining high viscosity etchant "Applying" step.
FIG. 8 is a schematic cross-sectional view for explaining "Heating", "Reacting", and "Drying" steps.
FIG. 9 is a partially enlarged diagram of applied-area of high viscosity etchant.
FIG. 10 is a schematic partial cross-sectional view of "Washing" step.
FIG. 11 is a diagram showing a conventional art.
FIG. 12 is a diagram taken on line XII-XII of FIG. 11.

### Description of the Preferred Embodiments

The present invention will be explained as follows. As described above, a thin surface layer 18 is forced to be formed on all of side and all of reverse of a photovoltaic element substrate 12, even if to be formed only on all of outer surface or a single surface of the photovoltaic element substrate 12 with doping method. This requires an electrical separation of a thin surface layer 18 which forms a p-n junction S on a surface side as a necessary-area from a reverse electrode forming-area. On this embodiment, a case that the thin surface layer 18' is formed not only on the necessary-area but on the side and all of the reverse as an out of the necessary-area will be explained as a typical example. All kinds of photovoltaic element substrates 12 which have a thin surface layer 18 of a p-n junction S on its surface are included in a scope of this invention. On this embodiment, a case that the thin surface layer 18, 18' is formed with an n-layer and a base layer is formed with a p-type will be explained as a typical example.

According to the present invention, a solar cell 10 and a solar cell module M have constructions which are described in above "Description of the Related Art" basically. The point of difference between the present invention and the related art is to remain a part of the thin surface layer18' of the reverse electrode forming-area R by selective etching narrowly along a outer circumference edge of the reverse of the photovoltaic element substrate 12 without removing all of the thin surface layer 18' which is forced to be formed on the side and the reverse of the photovoltaic element substrate 12, see FIG.2. It is allowable to select-etch only all of the side of the photovoltaic element substrate 12, or to select-etch all of the side and the outer circumference edge of the reverse of the photovoltaic element substrate 12.

The photovoltaic element substrate 12 used in this embodiment has a thickness of 50 µm to 300 µm And the substrate 12 has the very thin n-layer (the thin surface layer 18) on its surface by thermal diffusion of a small amount of phosphorus (P). After an extremely thin anti-reflection film (SiNₓ film; approximately 70 nm (nano meters)) is formed on the very thin n-layer (not shown), a surface electrode 15 is formed.

The thin surface layer 18 includes any material that is etched with alkaline. The reverse of the thin surface layer may be shown as [18'] according to a necessity of a difference between the surface of thin surface layer 18 which has a relation with the p-n junction S and the reverse.

To make the solar cell 10, the "X" part, which surrounds the reverse electrode forming-area R, of the thin surface layer 18' of the photovoltaic element substrate 12 is removed with a wet etching method as described follows. Then the thin surface layer 18' within the revere electrode forming-area R is separated from the surface of the thin surface layer 18 which contributes to power generation. After that, the reverse electrode 14 and the surface electrode 15 are formed. The n-layer (the surface thin layer 18) has a thickness of 0.1 to 0.5 µm through which sunlight having some spectrums for power generation can pass. The p-n junction S is formed by uniting the p-layer which forms the base layer 17 and the n-layer which forms the thin surface layer 18.

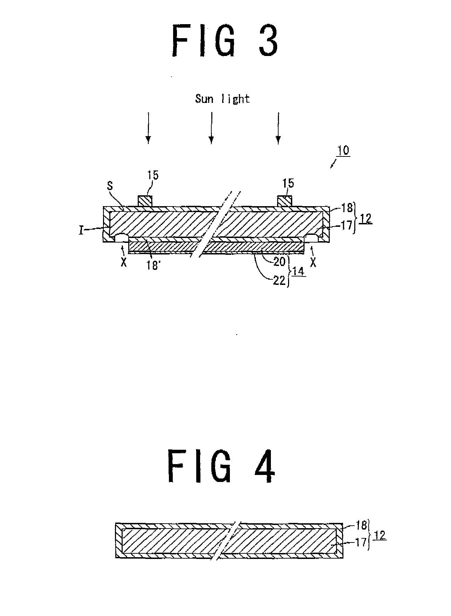

The surface of the n-layer which is the thin surface layer 18 of the photovoltaic element substrate 12 is an effective light receiving surface. As shown in FIG.3, the effective light which is received by the surface of the thin surface layer 18 passes through to the p-n junction S, a potential difference is generated between the base layer 17 and the thin surface layer 18. An electric current will be generated by connecting the reverse electrode 14 and the surface electrode 15 through a load.

The reverse electrode 14 includes aluminum (AI) layer 20 which is electrically connected to the base layer 17 and a silver (Ag) layer 22 which can be soldered and is stacked on the aluminum layer 20. And the reverse electrode 14 is connected to the thin surface layer 18' of the reverse electrode forming-area R which is electrically separated from the thin surface layer 18 forming the p-n junction S on the surface with only electrical resistance (no capacitance and inductance, called "ohmic contact").

The surface electrode 15 has a narrow band in shape and is made from silver. And the surface electrode 15 is electrically connected to the thin surface layer 18 with sintering the silver of the surface electrode 15 to silicon through the anti-reflection film (not shown) at 400 to 500 °C. To avoid shutting out the effective light to the surface layer 18, the surface electrode 15 is the narrow band in shape.

A plural of the photovoltaic element substrates 12 are arranged a line or some lines with gaps between each of the substrates 12. After a series connection of the substrates 12 is formed with lead wires 16, the solar cell module M is formed by fixing with glass plates and plastic films and assembling the substrates 12. Photovoltaic equipment is produced by packaging the solar cell module M.

A basic procedure for manufacturing the photovoltaic element substrate 12 for the solar cell 10 will be explained as follows. First, a texture etching with an alkali etching method is performed to the surface of the photovoltaic element substrate 12 which is obtained by slicing a high-grade silicon ingot including a small amount of boron. By the texture etching, the surface of the photovoltaic element substrate 12 is roughed with many micro pyramid projections. This greatly increases an area of the surface of the photovoltaic element substrate 12. Increasing an effective light receiving area causes an increase of an amount of power generation to increase. After applying a dopant (gas or liquid) to the surface of the photovoltaic element substrate 12, the substrate 12 is heated in 20 minutes at about 900 °C under nitrogen gas atmosphere. This makes phosphorus-diffused layer (the thin surface layer 18) not only on the surface but side or reverse of the photovoltaic element substrate 12 (see FIG.4).

During this phosphorus diffusing, oxidized film is produced with oxygen included in the dopant which includes phosphorus under a nitrogen atmosphere. The oxidized film is a phosphorus silicate acid glass film (PSG). This insulation film is removed by etching with hydrofluoric acid solution and washing.

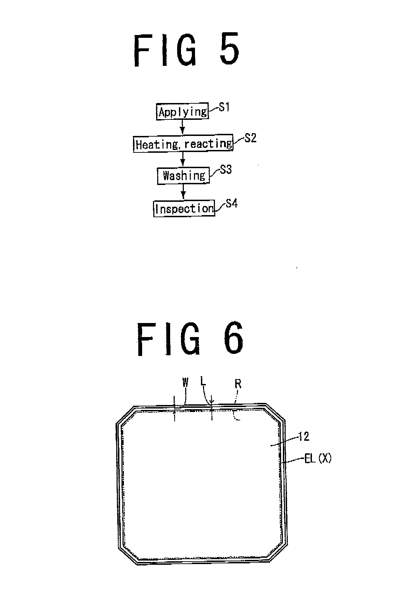

To separate the thin surface layer 18, a main part of power generation, of the photovoltaic element substrate 12 from the reverse electrode forming-area R, a wet etching method as shown in FIG.5 is done. The wet etching method used for this embodiment comprises "Applying step S1", "Heating and reacting step S2", "Washing step S3", and "Inspection step S4".

"Applying step S1" is to apply the high viscosity etchant EL with a set width W and almost square shape to an area inside by set distance L from an outer edge of the photovoltaic element substrate 12 on the thin surface layer 18' around the reverse electrode forming-area R of the photovoltaic element substrate 12 (see FIG.6). In this embodiment, the high viscosity etchant EL is applied to the area inside by 1 mm (distance L) from the outer edge of the photovoltaic element substrate 12. And the area has 2 to 3 mm width W. The applied area of the high viscosity etchant EL is indicated with "X". The distance L and the width W may be set as to conditions of a size of the reverse electrode 14, or the like.

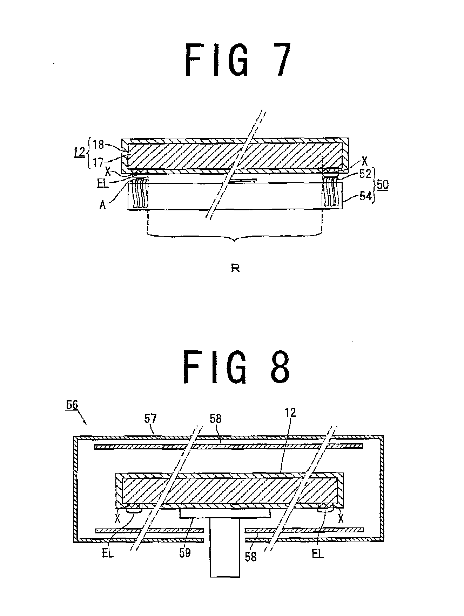

In the "Applying step S1", as shown FIG.7, a stamp 50 is used as a tool for applying the high viscosity etchant EL to the applied-area X of reverse of the photovoltaic element substrate 12 which is set to a level. The stamp 50 includes an etchant applying part 52 applying the high viscosity etchant EL to the set part by pushed onto the reverse of the photovoltaic element substrate 12; an etchant supplying part 54 supplying the high viscosity etchant EL to the etchant applying part 52 by capillary phenomenon, or the like. An inkjet or a dispenser (a long tube like a hypodermic needle) can be used instead of the stamp 50.

The etchant applying part 52 has very high rate of water retention, because it is formed by bundling high polymer fibers like mohair which has long bristles. Consequently, much amount of the high viscosity etchant EL can be kept between each of the high polymer fibers of the etchant applying part 52.

The etchant of the high viscosity etchant EL is an alkaline solution such as sodium hydroxide (NaOH), potassium hydroxide (KOH), or the like for silicon etching. And the viscosity increasing additive is an aqueous paste which is formed by heating after kneading material derived from a plant such as flour, starch of dogtooth violet, cornstarch, or the like. Because the viscosity increasing additive added to the high viscosity etchant EL of the present invention is derived from a plant, the viscosity of the high viscosity etchant EL does not decrease by adding to the alkaline solution for silicon etching (a viscosity of an etchant using a viscosity increasing additive which is derived from an animal will decrease.)

The viscosity of the high viscosity etchant EL is regulated approximately 3,000 to 4,000 cp (centipoises). Comparing with a conventional etchant (50 % solution of sodium hydroxide) which has a few cp in viscosity same as water, the viscosity of the high viscosity etchant EL is high enough. Regulation of viscosity is important. Undesirable low viscosity causes undesirable spreading of etchant and undesirable thin etchant, with shortage of a depth of the etching. But, because the high viscosity etchant EL according to the present invention does not spread on the surface of the photovoltaic element substrate 12 undesirably, a selective etching which the etchant EL is applied to the side I or an edge of the reverse of the photovoltaic element substrate 12 can be done.

Kinds of the etchant and the viscosity increasing additive are not limited to sodium hydroxide and flour. An aqueous paste which is formed by heating after kneading material (includes flour) derived from a plant such as starch of dogtooth violet, cornstarch, or the like can be used as the viscosity increasing additive. The viscosity of the high viscosity etchant EL is regulated according to an affinity between the photovoltaic element substrate 12 and the high viscosity etchant EL by selecting an adding rate of the viscosity increasing additive.

"Heating and reacting step S2" is to heat the photovoltaic element substrate 12 with the high viscosity etchant EL for accelerating the etching reaction, and to react the high viscosity etchant EL to the photovoltaic element substrate 12. In this "heating and reacting step S2", as shown FIG.8, a hot plate type contact heater 56 is used for heating the photovoltaic element substrate 12 with the high viscosity etchant EL.

The contact heater 56 has a tunnel structure. A central portion of the photovoltaic element substrate 12 is stuck by a vacuum sticker 59. The vacuum sticker 59 has a circular structure routing in and out of a heating tunnel 57. The photovoltaic element substrate 12 is heated through the heating tunnel 57 by conveying continuously or intermittently. And the photovoltaic element substrate 12 passes over a hot plate 58 in approximately 2 mm distance with the treating surface facing downward. Etching is done while the photovoltaic element substrate 12 is passed over.

The reason of heating the photovoltaic element substrate 12 with the high viscosity etchant EL is that the etchant of the high viscosity etchant EL including alkaline solution such as sodium hydroxide reacts very slowly at normal temperature with the photovoltaic element substrate 12. The speed of the reaction can be faster by heating the photovoltaic element substrate 12. By heating the photovoltaic element substrate 12 with the contact heater 56 at 60 to 100 °C, the photovoltaic element substrate 12 will be etched to approximately 1 µm depth (the depth that the base layer 17 can be exposed.) in 30 seconds to 1 minute, with a quick reaction between the etchant and the thin surface layer 18 of the photovoltaic element substrate 12 on the surface. The speed of etching is depends on concentrations, viscosities of NaOH or KOH of the etchant, and heating temperature.

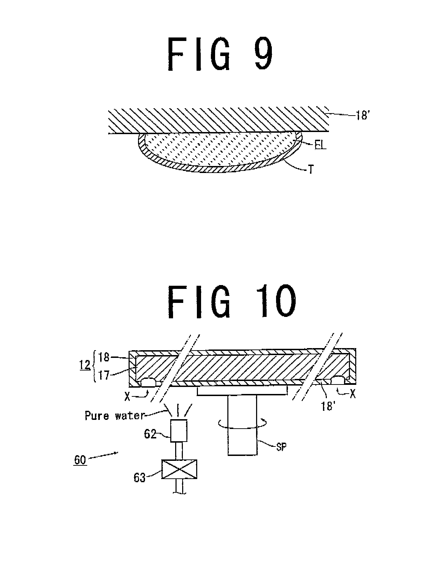

After evaporating of moisture of the high viscosity etchant EL from surface of the etchant EL in etching, as shown in FIG.9, only the viscosity increasing additive derived from a plant remains on the surface. Then the viscosity increasing additive is getting harder by the evaporation and forms a hard film T. Then the high viscosity etchant EL is wrapped with the hard film T. The evaporation is suppressed after forming the hard film T. As a result, the surface of the photovoltaic element substrate 12 is etched to a set depth.

In etching, in case that reaction gas which is generated by a reaction between the high viscosity etchant EL and the photovoltaic element substrate 12 spreads out with particles of the high viscosity etchant EL, appearance of the photovoltaic element substrate 12 will be deteriorated. Because the treating surface faced downward, the spread -out particles will fall down. This results that the particles will not added to the photovoltaic element substrate 12.

Further, in this "Heating and reacting step S2", because the treating surface of the photovoltaic element substrate 12 with the high viscosity etchant EL faced downward, a cross-section of the applied high viscosity etchant EL becomes a semisphere or a dome-shape by the gravity and a surface tension. And the film T is formed on the surface. The film T keeps the high viscosity etchant EL from drying. It causes a continuation of the etching as long as the moisture remains in the etchant and the particles of the high viscosity etchant EL in etching reaction being prevented.

In this embodiment of the etching method, the photovoltaic element substrate 12 is heated after the application of the high viscosity etchant EL. The application of the high viscosity etchant EL may be done after the heating. In this case, the reaction between the photovoltaic element substrate 12 and the high viscosity etchant EL will be started soon after the application of the high viscosity etchant EL to the photovoltaic element substrate 12. As a result, the etching time is shortened.

"Washing step S3" is to remove the remains of the viscosity increasing additive on the reverse of the photovoltaic element substrate 12 by water washing the photovoltaic element substrate 12. In this step, a washer 60 as shown in FIG.10 is is used.

The washer 60 is for washing out the viscosity increasing additive as the remains on the reverse of the photovoltaic element substrate 12, and includes a water spray device 62 for spraying pure water; a water heater 63 for heating the pure water sprayed from the water spray device on demand.

The photovoltaic element substrate 12 which treated the "Heating and reacting step S2" is sprayed heated dilute hydrochloric aid solution (1 to 3 %) before the "Washing step S3" to neutralize the alkaline solution in the high viscosity etchant EL remained on the surface of the photovoltaic element substrate 12. Then the photovoltaic element substrate 12 is washed with the heated pure water sprayed from the water spray device 62. After removing the pure water by means of fast rotation of the spin check SP, the photovoltaic element substrate 12 is inspected by an inspection device, which is not shown (Inspection step S4). The inspection device checks whether the thin surface layer of the required area 18 is separated from the thin surface layer of the non-required area 18' completely or not. By getting a "good" result, the wet etching is completed. In case that the result is not good because of a lack of etching, the photovoltaic element substrate 12 will be etched again by returning to "application step S1".

Inside in the set length L from the circumference of the photovoltaic element substrate 12 on the reverse electrode forming area R same as the applied-area of the high viscosity etchant EL with the stamp 50 in "Applying step S1", the thin surface layer 18 with the set width W is removed from the photovoltaic element substrate 12 which is etched completely. (See "X" parts of the figures)

Finally, the reverse electrode 14 and the surface electrode 15 are provided to the photovoltaic element substrate 12 for the solar cell 10. The ohmic contact is applied between the reverse electrode 14 and the surface electrode 15, and the photovoltaic element substrate 12 such as described above. Then, the solar cell 10 is is completed.

## Claims

1. A high viscosity etchant (EL) comprising:
an etchant being an alkaline solution for exposing a base layer (17) with removing a part of a thin-surface layer (18) of a p-n junction (S) of a photovoltaic element substrate (12) of a solar cell;
a viscosity increasing additive derived from a plant for increasing a viscosity of the etchant (EL).

2. A selective etching method for removing a part of a surface of a thin surface layer (18) of a p-n junction (S) from a photovoltaic element substrate (12) having the p-n junction (S) to expose a base layer (17), comprising:
applying the high viscosity etchant (EL) according to claim 1 to a reverse electrode forming-area (R) which is formed on all of reverse of the photovoltaic element substrate (12) and/or all side of the substrate (12);
separating the thin surface layer (18) and the reverse electrode forming-area (R) by reacting the high viscosity etchant (EL) to an etchant-applied area of the photovoltaic element substrate (12) by heating the substrate (12);
removing the high viscosity etchant (EL) by washing the etchant (EL) with pure water.

3. The selective etching method according to claim 2, wherein the high viscosity etchant (EL) is reacted to the photovoltaic element substrate (12) of which the etchant-applied area (X) at a circumference of the reverse electrode forming-area (R) with holding the photovoltaic element substrate (12) upside down.
